# EUROPEAN PATENT APPLICATION

(11) **EP 3 772 246 A1**
(43) Date of publication of application: **03.02.2021**
(21) Application number: 19213505.1
(22) Date of filing: 04.12.2019
(51) Int. Cl.: H05K 7/20, G06F 1/20, H01L 23/46

(54) **THERMAL MANAGEMENT DEVICE AND METHOD OF USE**

(30) Priority: 02.08.2019 US 201916530612
(71) Applicant: Hamilton Sundstrand Corporation, Charlotte, NC 28217-4578 (US)
(72) Inventor: WANG, Jinliang, Elington, CT Connecticut 06029 (US); DWARI, Suman, Vernon, CT Connecticut 06066 (US); GUO, Ben, West Hartford, CT Connecticut 06117 (US)
(74) Representative: Dehns

(57) **Abstract**

A system including a thermal management body (100) having a central void (112) therein defined by a first panel (102) connected along a first side (104) thereof to a second panel (108) and to a third panel (108) along a second side thereof, and wherein the third panel is connected to the second panel along respective sides thereof opposite the first panel.

## Description

### Background

### Technological Field

The present disclosure relates to electronics thermal management, and more particularly to a three dimensional heat management arrangement.

### Description of Related Art

A variety of devices are known for providing a cooling solution for power electronics. Power electronics devices are usually mounted on a heat spreader or a cold plate or to a heat sink in order to cool them during operation. Typical packaging configuration usually results in a bulky two-dimensional design, which has a relatively high volume, especially for air cooled cases. The aerospace industry demands lightweight and high compactness packaging solutions while also significantly increasing power level requirements.

The conventional methods and systems have generally been considered satisfactory for their intended purpose, but are not appropriate any more when due to an increase in output powers of power electronics devices and volume and/or weight constrains remaining the same.. However, there is still a need in the art for a thermal management system with a reduced volume and/or weight and an increased power density. The present disclosure may provide a solution for at least one of these remaining challenges.

### Summary of the Invention

A system including a thermal management body having a central void therein defined by a first panel connected along a first side thereof to a second panel and to a third panel along a second side thereof, and wherein the third panel is connected to the second panel along respective sides thereof opposite the first panel. Each panel can include a respective chip array. Each chip array can be in thermal communication with each respective panel. Each panel can include at least one heat sinking fin extending into the central void, wherein the heat sinking fins of each corresponding panel can be of varying sizes and extend towards a center of the heat management body. The fins of each panel can be arranged in an increasing order of length towards a center of each panel. The fin can include a fluid-dynamic contour shaped to decrease fluid pressure drop.

The void can include a triangular cross-sectional shape. An angle between each of the panels can be acute. The void can include thermally conductive porous media, wherein the porous media can include metallic foam or carbon and graphite foam. The porous media can have a density of between 0.3 to 0.8 grams per cubic centimeter.

A method of cooling an electronic device includes attaching an electronic device to a thermal management system body having a central void, and passing a fluid through the central void in order to remove heat. Flowing can include passing the fluid over a series of fins or porous media in thermal communication with the panels to accept heat therefrom.

These and other features of the systems and methods of the subject disclosure will become more readily apparent to those skilled in the art from the following detailed description of the preferred embodiments taken in conjunction with the drawings.

### Brief Description of the Drawings

So that those skilled in the art to which the subject invention appertains will readily understand how to make and use the devices and methods of the subject invention without undue experimentation, preferred embodiments thereof will be described in detail herein below with reference to certain figures, wherein:
Fig. 1 is a perspective view of a thermal management system for an electronic device array;
Fig. 2 is a cross-section view of Fig. 1, showing the arrangement of the fins; and
Fig. 3 is a perspective view of Fig. 1, showing the porous media within the central void.

### Detailed Description

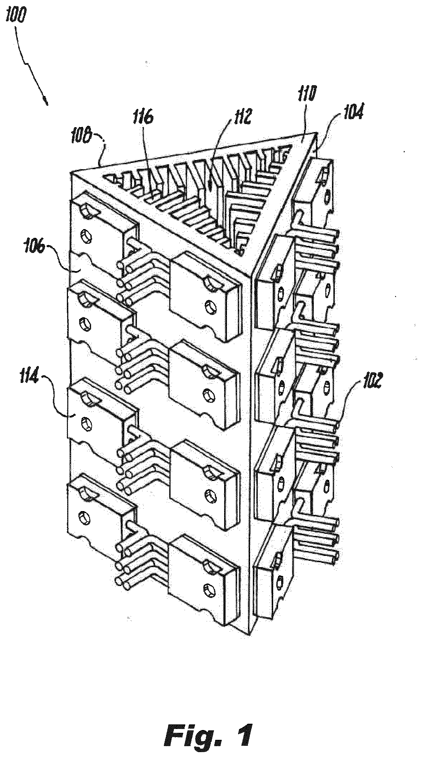

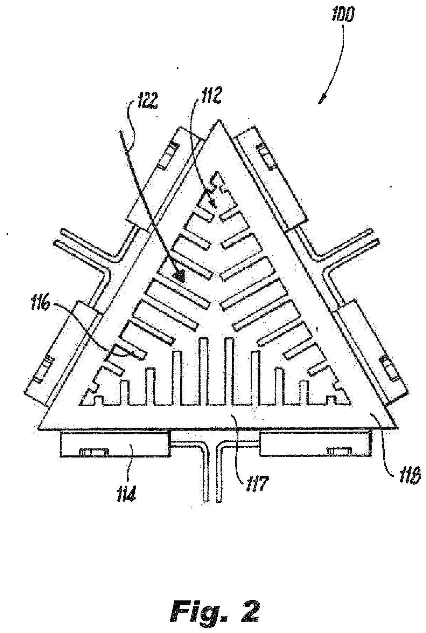

Reference will now be made to the drawings wherein like reference numerals identify similar structural features or aspects of the subject invention. For purposes of explanation and illustration, and not limitation, a partial view of an exemplary embodiment of a thermal management body in accordance with the invention is shown in Fig. 1 and is designated generally by reference character 100. Other embodiments of the thermal management body in accordance with the invention, or aspects thereof, are provided in Figs. 2-3, as will be described. The methods and systems of the invention can be used to provide a more compact, lighter and more efficient electronics thermal management device.

As shown in Fig. 1, a thermal management body 100 includes a first panel 102 connected along a first side 104 thereof to a second panel 106 and to a third panel 108 along a second side 110 thereof. The third panel 108 is connected to the second panel 106. The panel 102, 106, 108 form a void 112 at the center. The void 112 is a triangular fluid path. Each panel 102, 106, 108 includes a respective chip array 114, placed thereon. Each chip array 114 is in thermal communication with each respective panel 102, 106, 108 through an electric insulated thermal interface layer. As the chips 114 heat up, the panels 102, 106, 108 accept the heat and transfer it to the void 112. This arrangement reduces system volume and weight and while increasing power density. The arrangement further helps maintain and improve thermal performance while providing the flexibility of multi-side configuration. The arrangement provides a robust design solution for applications where space constrain is a challenge.

Referring to Fig. 2, each panel 102, 106, 108 includes heat sinking fins 116 extending into the void 112. The fins 116 of each corresponding panel 102, 106, 108 are of varying sizes and optimized. The fins 116 of each panel 102, 106, 108 are arranged such that higher fins 116 are located at closer to the center 117 of each panel 102, 106, 108 and shorter fins 116 are placed closer to the periphery 118, or edge, of each channel. The fins 116 can be contoured to decrease the pressure drop of fluid flow through the void. The fins 116 act as a heat sink for the electronic chips 114. A fluid 122 can be passed through the central void 112 and around the fins 116 in order to remove heat from the fins. The fluid can be a gas, such as air or a liquid such as water. The arrangement of the fins, provides a design that fully utilizes the space of the void, while providing an efficient heat sink to each of the panels 102, 106, 108.

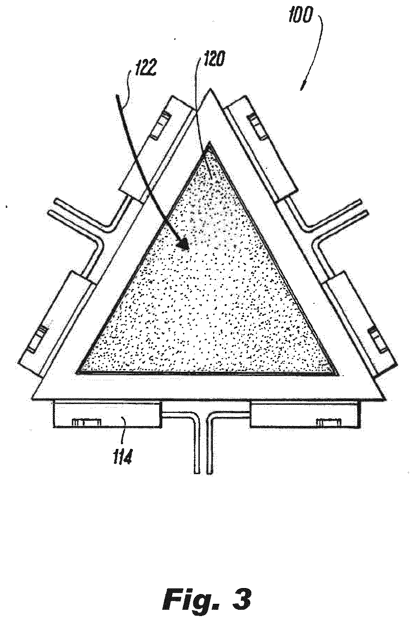

Fig. 3, shows porous media 120 located within the void 112. The porous media 120, through which fluid 122 can flow is placed also for thermal conductivity. The porous media can include metallic foam or carbon/graphite foam, and have a density of between 0.3 to 0.8 grams per cubic centimeter. The porous media 120 can be used with or without the fins 116 within the void.

The methods and systems of the present disclosure, as described above and shown in the drawings, provide for electronics thermal management system with superior properties including increased reliability and reduced size and weight. While the apparatus and methods of the subject disclosure have been shown and described with reference to embodiments, those skilled in the art will readily appreciate that changes and/or modifications may be made thereto without departing from the scope of the invention as defined by the claims.

## Claims

1. A system comprising:
a thermal management body (100) having a central void (112) therein defined by a first panel (102) connected along a first side (104) thereof to a second panel (106) and to a third panel (108) along a second side (110) thereof, and wherein the third panel is connected to the second panel along respective sides thereof opposite the first panel.

2. The system of claim 1, wherein each panel includes a respective chip array (114).

3. The system of claim 2, wherein each chip array is in thermal communication with each respective panel.

4. The system of any preceding claim, wherein each panel includes at least one heat sinking fin (116) extending into the central void, and preferably wherein the at least one heat sinking fin includes multiple heat sinking fins for each panel.

5. The system of claim 4, wherein the heat sinking fins of each corresponding panel are of varying sizes.

6. The system of claim 4 or 5, wherein the fins extend towards a center of the heat management body.

7. The system of claim 4, 5 or 6, wherein the fins of each panel are arranged in an increasing order of length towards a center of each panel.

8. The system of any of claims 4 to 7, wherein the or each fin has a fluid-dynamic contour to decrease fluid pressure drop.

9. The system of any preceding claim, wherein the void has a triangular cross-sectional shape.

10. The system of any preceding claim, wherein the void includes thermally conductive porous media (120).

11. The system of claim 10, wherein the porous media includes metallic foam, or wherein the porous media includes carbon and graphite foam.

12. The system of claim 10 or 11, wherein the porous media has a density of between 0.3 to 0.8 grams per cubic centimeter, inclusive.

13. The system of any preceding claim, wherein an angle between each of the panels is acute.

14. A method of cooling an electronic device comprising:
attaching an electronic device to a thermal management system body having a central void; and
passing a fluid through the central void defined by three panels in order to remove heat.

15. The method of claim 14, wherein flowing includes passing the fluid over a series of fins, or wherein flowing includes passing the fluid through porous media in thermal communication with the panels to accept heat therefrom.
